Europäisches Patentamt

European Patent Office

Office européen des brevets

(19)

(11) Numéro de publication : **0 309 366 B1**

## (12) FASCICULE DE BREVET EUROPEEN

(45) Date de publication du fascicule du brevet :
**29.01.92 Bulletin 92/05**

(51) Int. Cl.⁵ : **H03F 1/30**

(21) Numéro de dépôt : **88420316.7**

(22) Date de dépôt : **19.09.88**

(54) **Amplificateur différentiel de courant à fonctionnement séquentiel.**

(30) Priorité : **21.09.87 FR 8713333**

(43) Date de publication de la demande :
**29.03.89 Bulletin 89/13**

(45) Mention de la délivrance du brevet :
**29.01.92 Bulletin 92/05**

(84) Etats contractants désignés :
**DE FR GB IT NL SE**

(56) Documents cités :
**FR-A- 2 167 404**
**US-A- 3 237 116**
**US-A- 3 321 628**

(56) Documents cités :
**ELECTRONIC DESIGN, vol. 33, no. 7, 21 mars 1985, pages 143-146,148,150,152, Hasbrouch Heights, New Jersey, US; K. HOSKINS: "Autozero chip cuts op amp offset voltages to a mere +- 5 muV"**

(73) Titulaire : **SGS-THOMSON MICROELECTRONICS S.A.**
**7, Avenue Galliéni**
**F-94250 Gentilly (FR)**

(72) Inventeur : **Ramet, Serge**
**7 bis, Rue Gabriel Péri**
**F-38000 Grenoble (FR)**

(74) Mandataire : **de Beaumont, Michel et al**
**1bis, rue Champollion**
**F-38000 Grenoble (FR)**

EP 0 309 366 B1

Jouve, 18, rue Saint-Denis, 75001 PARIS

## Description

La présente invention concerne un amplificateur différentiel de courant permettant de comparer avec une très haute précision deux courants et de fournir une tension de sortie qui soit proportionnelle à la différence entre ces courants.

Il est connu que, quand on cherche à comparer des courants avec une grande précision au moyen de circuits intégrés, on est limité par ce que l'on appelle la tension de décalage ou tension d'offset des amplificateurs différentiels. Cette tension de décalage est la différence entre les tensions d'entrée pour une tension nulle à la sortie.

Pour compenser cette tension d'offset, il est connu d'utiliser des amplificateurs dits à auto-zéro fonctionnant selon un mode séquentiel.

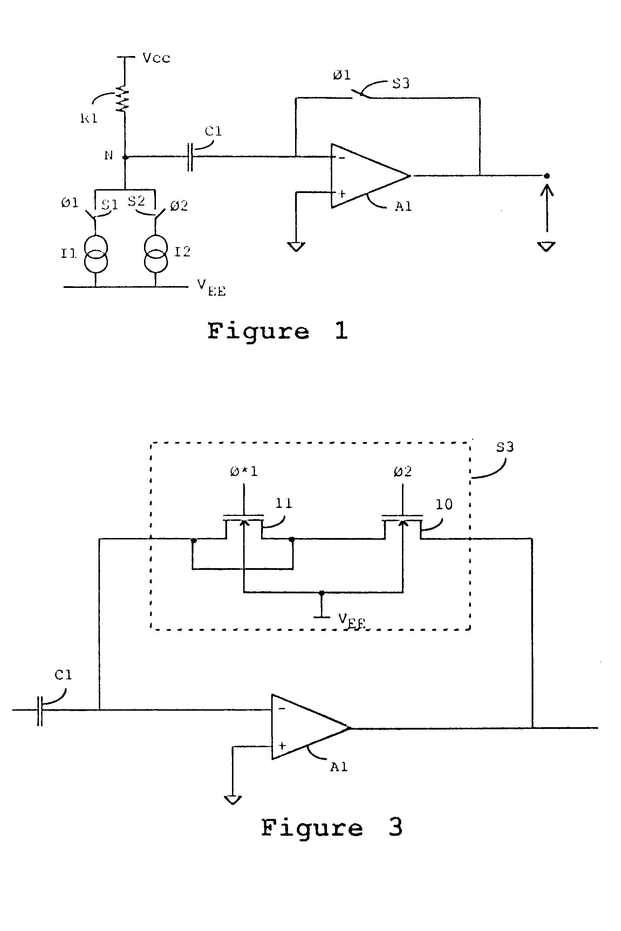

Un tel amplificateur-comparateur à fonctionnement séquentiel va être décrit en relation avec la figure 1. Dans cette figure, on peut voir les deux sources de courant à comparer I1, I2 connectées entre une tension de référence basse VEE et des commutateurs respectifs S1 et S2 respectivement fermés pendant des phases disjointes φ1 et φ2. Les autres bornes des commutateurs S1 et S2 sont reliées à un noeud N. Le neoud N est relié à une source d'alimentation haute VCC par l'intermédiaire d'une résistance R1. Le neoud N est également relié à la première entrée (–) d'un amplificateur différentiel A1 par l'intermédiaire d'un condensateur C1. La deuxième entrée de l'amplificateur différentiel A1 est reliée à une source de tension de valeur intermédiaire, couramment la masse dans le cas où la tension haute VCC est positive et où la tension basse VEE est négative. L'entrée et la sortie de l'amplificateur A1 sont bouclées par l'intermédiaire d'un commutateur S3 fermé pendant la phase φ1 durant laquelle la source de courant I1 est connectée par le premier interrupteur S1.

Le fonctionnement de ce circuit est le suivant.

Pendant une première phase, φ1, les interrupteurs S1 et S3 sont fermés et l'interrupteur S2 est ouvert. Le courant I1 parcourt la résistance R1 et le condensateur C1 se charge à la tension VCC — R1 I1 — Vos, où Vos est la tension d'offset de l'amplificateur A1.

Lors de la phase φ2, les interrupteurs S1 et S3 sont ouverts et l'interrupteur S2 est fermé. Le courant I2 parcourt la résistance R1 et la tension de sortie de l'amplificateur A1 est égale à :

$$V = G(A1) \, R1 \, [I1 - I2]$$

où G(A1) est le gain en boucle ouverte de l'amplificateur A1. On a ainsi, grâce à la phase φ1 dite phase d'auto-zéro, parfaitement compensé en théorie la tension d'offset de l'amplificateur A1. Il demeure toutefois une erreur liée à l'ouverture du commutateur S3 à la fin de la phase φ1. En effet, ce commutateur est généralement réalisé au moyen d'un transistor MOS et, à l'ouverture, une partie des charges stockées dans le canal du transistor se retrouve sur le condensateur C1 et cette injection de charges introduit une erreur. Si l'on veut pouvoir détecter un courant minimal I min de l'ordre de 1,5 microampères, la charge injectée doit être inférieure à Q min = CRI min. Avec des ordres de grandeur classiques, C = 10 pF, R = 300 ohms et I min = 1,5 µA, on arrive à :

$$Q \min = 4,5 \; 10^{-15} \; \text{coulombs}$$

(cette charge correspond à environ 28000 fois la charge d'un électron). Dans la pratique, il s'avère qu'il est impossible que la quantité de charges injectées par l'ouverture du commutateur S3 soit inférieure à cette valeur Q min même en utilisant des techniques de circuiterie qui permettent de minimiser l'injection de charges.

Ainsi, un objet de la présente invention est de prévoir un amplificateur différentiel de courant compensant non seulement la tension d'offset d'un amplificateur différentiel, mais permettant également de minimiser l'influence de l'injection de charge liée à l'ouverture d'un commutateur.

Pour atteindre ces objets ainsi que d'autres, la présente invention prévoit un dispositif de comparaison de courants muni d'un amplificateur différentiel de courant à compensation de tension de décalage et à fonctionnement séquentiel comprenant une source de tension haute, une source de tension basse, une source de tension intermédiaire, une première résistance reliée entre la source de tension haute et un noeud de connexion, une première source de courant connectée entre la source de tension basse et ledit noeud par un premier commutateur fermé pendant une première phase, une deuxième source de courant connectée entre la source de tension basse et ledit noeud par un deuxième commutateur fermé pendant une deuxième phase, un premier amplificateur différentiel dont une première entrée est reliée audit noeud par l'intermédiaire d'un premier condensateur, dont une deuxième entrée est reliée à la source de tension intermédiaire et dont la sortie est reliée à la première l'entrée par un troisième commutateur fermé pendant la première phase, une deuxième résistance de valeur élevée devant la première résistance connectée entre ledit noeud et la source de tension intermédiaire, et des moyens d'asservissement fonctionnant dans une phase préliminaire aux première et deuxième phases pour imposer que, quand le premier commutateur est fermé, le potentiel sur ledit noeud soit égal à celui de la source de tension intermédiaire et que le courant dans la première résistance est sensiblement égal au courant de la première source de courant.

Selon un mode de réalisation de la présente invention, les moyens d'asservissement comprennent un transistor bipolaire connecté entre la première résistance et ledit noeud ; un deuxième amplificateur différentiel dont une première entrée est connectée au point de connexion dudit transistor et de la première résistance, dont une deuxième entrée est connectée à un deuxième condensateur dont l'autre borne est reliée à la source de tension intermédiaire, et dont la sortie est connectée à la base dudit transistor ; et des moyens de commutation pour relier pendant la phase préliminaire la première entrée du premier amplificateur à la source de tension intermédiaire, la deuxième entrée du premier amplificateur audit noeud, et la sortie du premier amplificateur à la deuxième entrée du deuxième amplificateur.

Selon un mode de réalisation de la présente invention, les moyens de commutation comprennent un quatrième commutateur connecté entre le premier condensateur et ledit noeud, et un cinquième commutateur entre la deuxième entrée du premier amplificateur différentiel et la source de tension intermédiaire, ces quatrième et cinquième commutateurs étant ouverts pendant la phase préliminaire et fermés pendant les autres phases ; et un sixième commutateur connecté entre la deuxième entrée du premier amplificateur différentiel et ledit noeud, un septième commutateur connecté entre la première entrée du premier amplificateur différentiel et la source de tension intermédiaire et un huitième commutateur connecté entre la sortie du premier amplificateur différentiel et la deuxième entrée du deuxième amplificateur différentiel, ces sixième, septième et huitième commutateurs étant fermés pendant la phase préliminaire et ouverts pendant les autres phases.

Ainsi, la présente invention permet de mesurer des différences de courant extrêmement faibles. Par exemple, on cherche à détecter des différences de courant inférieures à 1,5 microampères sur une gamme de courants d'entrée allant de 800 microampères à 12,8 mA (ces valeurs correspondent à des valeurs couramment utilisées dans des convertisseurs analogiques/numériques).

Ces objets, caractéristiques et avantages ainsi que d'autres de la présente invention seront exposés plus en détail dans la description suivante de modes de réalisation particuliers de l'invention faite en relation avec les figures jointes parmi lesquelles :

la figure 1 décrite précédemment était destinée à illustrer l'état de la technique ;

la figure 2 représente un schéma d'un circuit selon la présente invention ; et

la figure 3 représente un exemple de commutateur à injection de charges réduites.

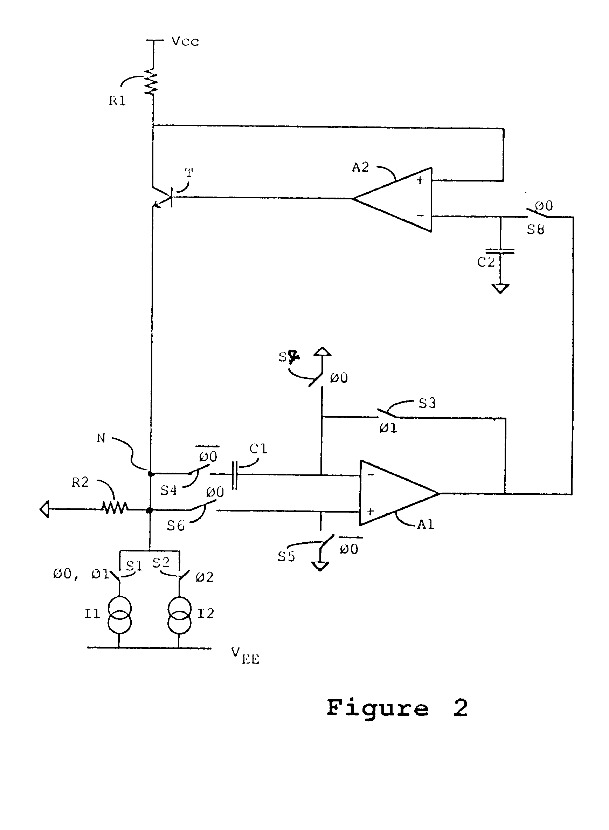

Dans la figure 2, des éléments déjà décrits en relation avec la figure 1 sont désignés par les mêmes références. On retrouve la résistance R1, le noeud N, les commutateurs S1 et S2 et les sources de courant I1 et I2, ainsi que l'amplificateur différentiel A1, le condensateur C1 et le commutateur S3.

En outre, un transistor bipolaire T de type NPN est connecté entre la résistance R1 et le noeud N. La base de ce transistor reçoit la sortie d'un deuxième amplificateur différentiel A2 dont la première entrée (+) est reliée au point de connexion entre le collecteur du transistor T et la résistance R1 et dont la deuxième entrée est reliée à un condensateur C2 dont l'autre borne est à la masse. Une résistance R2 est connectée entre le noeud N et la tension de référence intermédiaire.

D'autre part, il est prévu en plus des phases de fonctionnement $\phi1$ et $\phi2$ décrites précédemment une phase de fonctionnement supplémentaire $\phi0$ au cours de laquelle le commutateur S1 est fermé et où des commutateurs supplémentaires S4 à S8 sont actionnés. Le commutateur S4, connecté entre le condensateur C1 et le noeud N, et le commutateur S5, connecté entre la deuxième entrée de l'amplificateur A1 et la tension intermédiaire (normalement la masse), sont fermés en dehors de la phase $\phi0$, c'est-à-dire pendant les phases $\phi1$ et $\phi2$. On dira que ces commutateurs sont commandés par le signal $\phi*0$. Les commutateurs S6 à S8 sont eux fermés pendant la phase $\phi0$. Le commutateur S6 est disposé entre la deuxième entrée de l'amplificateur A1 et le noeud N, le commutateur S7 est connecté entre la première entrée de l'amplificateur A1 et la masse, et le commutateur S8 est connecté entre la sortie de l'amplificateur A1 et la deuxième entrée de l'amplificateur A2.

Ainsi, en dehors de la phase $\phi0$, c'est-à-dire pendant les phases $\phi1$ et $\phi2$, on retrouve sensiblement la même configuration que dans les phases $\phi1$ et $\phi2$ décrites en relation avec la figure 1 à l'exception de la présence de la résistance R2 et de celle du transistor T commandé par l'amplificateur A2 dont la deuxième entrée est reliée au condensateur C2.

La phase préliminaire $\phi0$ a pour but de fixer le potentiel au point N par action sur l'amplificateur A2 agissant lui-même sur le transistor T.

Ainsi, pendant la phase préliminaire, l'entrée (−) de l'amplificateur A1 est reliée à la masse par le commutateur 7 et son entrée (+) est reliée au noeud N par le commutateur S6 alors que sa sortie est reliée à l'entrée (−) de l'amplificateur A2 par le commutateur S8. Ainsi, l'ensemble des amplificateurs A1, A2 et du transistor T forme un circuit de réaction. Ce circuit s'équilibre quand l'entrée (+) de l'amplificateur A1 arrive au même potentiel que son entrée (−) qui est reliée à la masse. Il en résulte que le potentiel sur le noeud N est sensiblement celui de la masse et donc que, comme l'autre entrée de la résistance R2 est reliée à la masse, un courant nul tend à circuler dans cette résistance. Ainsi, tout le courant de la source de courant I1 circule dans la résistance R1.

Le condensateur C2 sert à maintenir l'état de l'amplificateur A2 et donc le courant de base dans le transistor T après ouverture du commutateur S8.

Ainsi, à la phase suivante qui, comme on le voit, est sensiblement identique à la phase $\phi 1$ du circuit de la figure 1, il passera toujours le même courant dans la résistance R1 et le noeud N restera toujours sensiblement au potentiel de la masse. Pendant cette phase $\phi 1$, comme préalablement, le condensateur C1 se polarise pour réaliser la compensation d'offset de l'amplificateur A1.

A la phase $\phi 2$, également sensiblement analogue à la phase $\phi 2$ de la figure 1, on obtiendra en sortie de l'amplificateur A1 un potentiel V égal à :

$$V = G(A1) \, R2 \, [I1 - I2]$$

La différence par rapport au cas de la figure 1 est que c'est la résistance R2 et non plus la résistance R1 qui intervient pour fixer la tension de sortie. Typiquement, on pourra choisir une résistance R1 d'une valeur de l'ordre de 30 ohms et une résistance R2 de l'ordre de 1000 ohms. Par contre, l'influence de l'ouverture du commutateur S3 à la fin de la phase $\phi 1$ entraînera la même injection de charge sur le condensateur C1 que dans le cas de la figure 1 mais l'influence de cette injection de charge sur la sortie de l'amplificateur A1 sera réduite par le rapport des valeurs des résistances R1 et R2, c'est-à-dire un rapport 30 dans le cas de l'exemple donné précédemment. Ainsi, pour obtenir une précision de mesure de différence de courant de l'ordre de 1,5 microampères, au lieu de ne pouvoir supporter qu'une charge injectée par l'ouverture d'un transistor MOS de l'ordre de $5 \cdot 10^{-15}$ coulomb, on pourra supporter une injection 30 fois plus importante, c'est-à-dire de l'ordre de $150 \cdot 10^{-15}$ coulomb ce qui est tout à fait réalisable pratiquement.

Ainsi, la présente invention permet d'augmenter d'un facteur 30, ou plus selon le rapport R2/R1, la précision minimale que l'on peut atteindre avec un amplificateur-comparateur de courant par rapport aux dispositifs de l'art antérieur.

On notera en outre que la précision de l'asservissement réalisé par la boucle A1, A2, T n'est pas critique car elle ne joue qu'au deuxième ordre, la phase préliminaire étant suivie d'une phase d'auto-zéro.

Bien entendu, la présente invention est susceptible de nombreuses variantes qui apparaîtront à l'homme de l'art. Les perfectionnements supplémentaires apportés classiquement aux circuits du type de celui de la figure 1 pourront être apportés aux circuits du type de celui de la figure 2 selon la présente invention. Notamment, on pourra utiliser comme commutateur S3 un commutateur à injection de charges réduites tel que celui représenté en figure 3.

A la figure 3, le commutateur S3 est mis en oeuvre par un transistor MOS 10 commandé par le signal $\phi 1$. Ce transistor 10 est en série avec un transistor MOS 11 dont le drain et la source sont court-circuités, appelé transistor MOS fantôme, dont la grille reçoit le signal $\phi^* 1$ complémentaire de $\phi 1$. Le transistor 11 est choisi pour que sa longueur de canal L2 soit égale à la longueur de canal L1 du transistor 10 et pour que sa largeur de canal W2 soit le double de celle, W1, du transistor 10 (ou plus généralement pour que 2W1/L1 = W2/L2). Les tensions de polarisation des substrats des transistors 10 et 11 sont identiques, égales à VEE en figure 3. Ainsi à l'ouverture du transistor 10, les charges qui seraient injectées dans le condensateur C1 sont compensées au premier ordre par le transistor 11.

## Revendications

1. Dispositif de comparaison de courants muni d'un amplificateur différentiel de courant à compensation de tension de décalage et à fonctionnement séquentiel comprenant :
— une source de tension haute (VCC),
— une source de tension basse (VEE),
— une source de tension intermédiaire,
— une première résistance (R1) reliée entre la source de tension haute et un noeud de connexion (N),
— une première source de courant (I1) connectée entre la source de tension basse et ledit noeud par un premier commutateur (S1) fermé pendant une première phase ($\phi 1$),
— une deuxième source de courant (I2) connectée entre la source de tension basse et ledit noeud par un deuxième commutateur (S2) fermé pendant une deuxième phase ($\phi 2$),
— un premier amplificateur différentiel (A1) dont une première entrée (−) est reliée audit noeud par l'intermédiaire d'un premier condensateur (C1), dont une deuxième entrée (+) est reliée à la source de tension intermédiaire, et dont la sortie est reliée à la première entrée par un troisième commutateur (S3) fermé pendant la première phase, caractérisé en ce qu'il comprend en outre:
— une deuxième résistance (R2) de valeur élevée devant la première résistance connectée entre ledit noeud et la source de tension intermédiaire, et
— des moyens d'asservissement ($A_2$, $C_2T$, $S_4$-$S_8$) fonctionnant dans une phase ($\phi 0$) préliminaire aux première et deuxième phases pour imposer que, quand le premier commutateur est fermé, le potentiel sur ledit noeud est égal à celui de la source de tension intermédiaire et que le courant dans la première résistance (R1) est sensiblement égal au courant de la première source de courant.

2. Dispositif selon la revendication 1, caractérisé en ce que les moyens d'asservissement comprennent :
— un transistor bipolaire (T) connecté par ses électrodes principales entre la première résistance et ledit noeud,

— un deuxième amplificateur différentiel (A2) dont une première entrée (+) est connectée au point de connexion dudit transistor et de la première résistance, dont une deuxième entrée (–) est connectée à un deuxième condensateur (C2) dont l'autre borne est reliée à la source de tension intermédiaire, et dont la sortie est connectée à la base dudit transistor, et

— des moyens de commutation (S4-S8) pour relier pendant la phase préliminaire le première entrée du premier amplificateur à la source de tension intermédiaire, la deuxième entrée du premier amplificateur audit noeud, et la sortie du premier amplificateur à la deuxième entrée du deuxième amplificateur.

3. Dispositif selon la revendication 2, caractérisé en ce que les moyens de commutation comprennent:

— un quatrième commutateur (S4) connecté entre le premier condensateur et ledit noeud, et un cinquième commutateur (S5) entre la deuxième entrée du premier amplificateur différentiel et la source de tension intermédiaire, ces quatrième et cinquième commutateurs étant ouverts pendant la phase préliminaire et fermés pendant les autres phases ; et

— un sixième commutateur (S6) connecté entre la deuxième entrée du premier amplificateur différentiel et ledit noeud, un septième commutateur (S7) connecté entre la première entrée du premier amplificateur différentiel et la source de tension intermédiaire et un huitième commutateur (S8) connecté entre la sortie du premier amplificateur différentiel et la deuxième entrée du deuxième amplificateur différentiel, ces sixième, septième et huitième commutateurs étant fermés pendant la phase préliminaire et ouverts pendant les autres phases.

**Claims**

1. A comparison device for currents provided with a differential current amplifier with offset compensation and with sequential operation comprising :
    — a high voltage source (VCC) ;
    — a low voltage source (VEE) ;
    — an intermediate voltage source ;
    — a first resistor (R1) connected between the high voltage source and a connection node (N) ;
    — a first current source (I1) connected between the low voltage source and said node through a first switch (S1) closed during the first phase (Φ1) ;
    — a second current source (I2) connected between the low voltage source and said node through a second switch (S2) closed during the second phase (Φ2) ;

— a first differential amplifier (A1), a first input (–) of which is connected with said node through a first capacitor (C1), the second input (+) of which is connected with the intermediate voltage source, and the output of which is connected with the first input by a third switch (S3) closed during the first phase ;

— a second resistor (R2) having a high value with respect to the first resistor connected between said node and the intermediate voltage source ; and

— servo-control means (A2, C2T, S4-S8) operating during a phase (Φ0) preliminary to said first and second phases for urging, when the first switch is closed, the voltage of said node to be equal to the intermediate voltage source and the current in the first resistor (R1) to be roughly equal to the current of the first current source.

2. A device according to claim 1, wherein the servo-control means comprise :

— a bipolar transistor (T) connected through its main electrodes between the first resistor and said node ;

— a second differential amplifier (A2), a first input (+) of which is connected with the connection point of said transistor and of the first resistor, the second input (–) of which is connected with a second capacitor (C2), the other terminal of which is connected with the intermediate voltage source, and the output of which is connected with the base of said transistor ; and

— switching means (S4-S8) for connecting during the preliminary phase the first input of the first amplifier with the intermediate voltage source, the second input of the first amplifier with said node, and the output of the first amplifier with the second input of the second amplifier.

3. A device according to claim 2, wherein the switching means comprise :

— a fourth switch (S4) connected between the first capacitor and said node, and a fifth switch (S5) between the second input of the first differential amplifier and the intermediate voltage source, those fourth and fifth switches being open during the preliminary phase and closed during the other phases ; and

— a sixth switch (S6) connected between the second input of the first differential amplifier and said node, a seventh switch (S7) connected between the first input of the first differential amplifier and the intermediate voltage source and a eighth switch (S8) connected between the output of the first differential amplifier and the second input of the second differential amplifier, those sixth, seventh and eighth switches being on during the preliminary phase and off during the other phases.

**Patentansprüche**

1. Stromvergleichsschaltung mit einem Stromdifferenzverstärker mit Nullpunkts-Spannungskompensation und sequentieller Wirkungsweise

— mit einer Quelle hoher Spannung (VCC),
— mit einer Quelle niedriger Spannung (VEE),
— mit einer Zwischenspannungsquelle,
— mit einem ersten Widerstand (R1), der zwischen die Quelle hoher Spannung und einen Schaltungspunkt (N) geschaltet ist,
— mit einer ersten Stromquelle (I1), die über einen, während einer ersten Phase ($\phi$1) geschlossenen ersten Schalter (S1) zwischen die Quelle niedriger Spannung und den Schaltungspunkt geschaltet ist,
— mit einer zweiten Stromquelle (I2), die über einen während einer zweiten Phase ($\phi$2) geschlossenen zweiten Schalter (S2) zwischen die Quelle niedriger Spannung und den Schaltungspunkt (N) geschaltet ist,
— mit einem ersten Differenzverstärker (A1), dessen erster Eingang (–) über einen ersten Kondensator (C1) mit dem Schaltungspunkt, dessen zweiter Eingang (+) mit der Zwischenspannungsquelle und dessen Ausgang über einen während der ersten Phase geschlossenen dritten Schalter (S3) mit seinem ersten Eingang verbunden ist, gekennzeichnet durch folgende weitere Merkmale :
— einen zweiten Widerstand (R2) mit einem gegenüber dem ersten Widerstand hohen Widerstandswert, der zwischen dem Schaltungspunkt und der Zwischenspannungsquelle gelegen ist, und
— eine Servosteuerung (A2, C2, T, S4 bis S8), die in einer der ersten und zweiten Phase vorausgehenden Phase ($\phi$0) wirkt und dafür sorgt, daß dann, wenn der erste Schalter geschlossen ist, das Potential am Schaltungspunkt gleich demjenigen der Zwischenspannungsquelle und der Strom im ersten Widerstand (R1) im wesentlichen gleich demjenigen der ersten Stromquelle ist.

2. Schaltung nach Anspruch 1, dadurch gekennzeichnet, daß die Servosteuerung folgende Merkmale aufweist :
— einen bipolaren Transistor (T), der mit seinen Hauptelektroden zwischen den ersten Widerstand und den Schaltungspunkt geschaltet ist,
— einen zweiten Differenzverstärker (A2), dessen erster Eingang (+) mit dem Verbindungspunkt zwischen Transistor (T) und erstem Widerstand, dessen zweiter Eingang (–) mit einem mit seinem zweiten Anschluß mit der Zwischenspannungsquelle verbundenen zweiten Kondensator (C2) und dessen Ausgang mit der Basis des Transistors verbunden ist und
— eine Schalteinrichtung (S4 bis S8), um in der vorausgehenden Phase den ersten Eingang des ersten Verstärkers mit der Zwischenspannungsquelle, den zweiten Eingang des ersten Verstärkers mit dem Schaltungspunkt und den Ausgang des ersten Verstärkers mit dem zweiten Eingang des zweiten Verstärkers zu verbinden.

3. Schaltung nach Anspruch 2, dadurch gekennzeichnet, daß die Schalteinrichtung folgende Merkmale aufweist :
— einen vierten Schalter (S4), der zwischen den ersten Kondensator und den Schaltungspunkt geschaltet ist, und einen fünften Schalter (S5) zwischen dem zweiten Eingang des ersten Differenzverstärkers und der Zwischenspannungsquelle, wobei der vierte und fünfte Schalter während der vorausgehenden Phase geöffnet und während der anderen Phasen geschlossen sind ; und
— einen sechsten Schalter (S6), der zwischen den zweiten Eingang des ersten Differenzverstärkers und den Schaltungspunkt geschaltet ist, einen siebten Schalter (S7), der zwischen den ersten Eingang des ersten Differenzverstärkers und die Zwischenspannungsquelle geschaltet ist, sowie einen achten Schalter (S8), der zwischen den Ausgang des ersten Differenzverstärkers und den zweiten Eingang des zweiten Differenzverstärkers geschaltet ist, wobei der sechste, siebte und achte Schalter während der vorausgehenden Phase geschlossen und während der anderen Phasen geöffnet sind.

Figure 1

Figure 3

Figure 2